(19) Europäisches Patentamt
European Patent Office
Office européen des brevets

(11) EP 4 612 228 B1

(12) **EUROPEAN PATENT SPECIFICATION**

(45) Date of publication and mention of the grant of the patent:
**06.05.2026 Bulletin 2026/19**

(21) Application number: **23700928.7**

(22) Date of filing: **11.01.2023**

(51) International Patent Classification (IPC):
***C08K 3/08*** *(2006.01)* ***C09D 183/04*** *(2006.01)*
***C09J 183/04*** *(2006.01)* ***H01L 23/36*** *(2006.01)*

(52) Cooperative Patent Classification (CPC):
(C-Sets available)
**C09D 183/04; C08K 3/08; C08K 7/00; C08L 83/04; C09J 183/04;** C08K 2003/0806; C08K 2201/001; C08K 2201/003; C08K 2201/005; C08K 2201/006; H10W 40/251; H10W 40/70 (Cont.)

(86) International application number:
**PCT/EP2023/050570**

(87) International publication number:
**WO 2024/149458 (18.07.2024 Gazette 2024/29)**

(54) **SILICONE BASED RESIN COMPOSITION, AND SEMICONDUCTOR DEVICE COMPRISING THE SAME**

SILIKONHARZZUSAMMENSETZUNG UND HALBLEITERBAUELEMENT DAMIT

COMPOSITION À BASE DE RÉSINE DE SILICONE ET SEMICONDUCTEUR COMPRENANT CELLE-CI

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**10.09.2025 Bulletin 2025/37**

(73) Proprietor: **Wacker Chemie AG**
**81671 München (DE)**

(72) Inventors:
- **CHOI, JongHak**
  **Seongnam-si Gyeonggi-do 13494 (KR)**
- **JOO, YoungHyuk**
  **Seongnam-si Gyeonggi-do 13494 (KR)**
- **KIM, TaeJoon**
  **Seongnam-si Gyeonggi-do 13494 (KR)**
- **LEE, JunGyu**
  **Seongnam-si Gyeonggi-do 13494 (KR)**

(74) Representative: **Mieskes, Klaus Theoderich et al**
**Wacker Chemie AG**
**Gisela-Stein-Straße 1**
**81671 München (DE)**

(56) References cited:
**EP-A1- 3 533 836**
**CN-A- 109 777 335**
**CN-A- 110 079 266**
**US-A1- 2004 203 268**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)

C-Sets
**C08K 3/08, C08L 83/04;**
**C08K 7/00, C08L 83/04;**
**C08L 83/04, C08L 83/00, C08K 5/56, C08K 3/08, C08K 3/08, C08K 7/00;**
C08K 2003/0806, C08L 83/04;
C08K 2201/001, C08L 83/04;
C08K 2201/003, C08L 83/04;
C08K 2201/005, C08L 83/04;
C08K 2201/006, C08L 83/04

## Description

[Technical Field]

The present invention relates to a silicone-based resin composition and a semiconductor device including the same.

[Background Art]

Since most electronic components generate heat during use thereof, it is necessary to remove heat from the electronic components for the proper operation thereof. In particular, in integrated circuit elements such as CPUs used in personal computers, the amount of heat dissipated is increasing due to an increase in operating frequency, whereby countermeasures against heat have emerged as an important issue.

Accordingly, many methods of dissipating such heat have been proposed, and in electronic components dissipating a large amount of heat, a method of dissipating heat by interposing a thermally conductive material, such as thermally conductive grease or a thermally conductive sheet, between an electronic component and a member such as a heat sink has been proposed. Korean Patent Application Publication No. 10-2020-0086307 discloses a semiconductor device including a thermally conductive material.

Patent document 2 describes a silicone composition comprising an organopolysiloxane and 200 parts by weight of a flaky silver powder as heat conductive filler having an average particle size of 2.5 μm, a tap density of 5.0 g/cm 3 and a specific surface area of 0.80 $m^2$/g. The thermal conductive silicone composition is used in the production of a semiconductor device wherein the silicone composition is interposed between the surface of a heat-generating electronic part and a heat dissipater.

Patent document 3 relates to a silicone composition comprising an organopolysiloxane and 500 parts by weight of a granular silver powder as heat conductive filler having an average particle size of 7.3 μm, a tap density of 1.4 g/$cm^3$ and a specific surface area of 0.60 $m^2$/g. The thermal conductive silicone composition is used in the production of a semiconductor device wherein the silicone composition is interposed between conductive contact elements and the surface of an electric connector of a semiconductor device.

Patent document 4 describes a silicone composition used as a thermoconductive paste in the manufacture of semiconductor devices. The silicone composition comprises an organopolysiloxane and 65 wt.% of a flaky-like silver powder having a tap density of 4.0-6.5 g/cm 3, a specific surface area of 0.4-1.5 $m^2$/g, a particle size D50 of 2.5-8.0 μm and an ignition loss of less than 1.0%.

Finally, patent document 5 discloses a resin composition comprising an organopolysiloxane, a silver powder and nano-silver modified carbon nanotubes. The silver powder is characterised by a tap density of 2.4-4.0 g/$cm^3$, a specific surface area of 1.2-2.5 $m^2$/g, a particle size D50 of 4.0-6.1 μm and an ignition loss of less than 1%. The thermal conductive silicone composition is used in the production of a semiconductor device as a heat conductive adhesive and provides connection between the chip and the heat sink.

However, a thermally conductive material has variations in hardness depending on process conditions, which has caused a problem in that the reliability of product performance is decreased due to differently expressed thermal conductivity characteristics.

[Related Art Document]

[Patent Document]

(Patent Document 1) Korean Patent Application Publication No. 10-2020-0086307
(Patent Document 2) European Patent Application Publication EP 3 533 836
(Patent Document 3) United States Patent Application Publication No. 2004/203268
(Patent Document 4) Chinese Patent Application Publication No. 109 777 335
(Patent Document 5) Chinese Patent Application Publication No. 110 079 266

[Disclosure]

[Technical Problem]

In accordance with an aspect of the present invention, the above and other objects can be accomplished by the

provision of a silicone-based resin composition with minimized thermal conductivity variation and excellent mechanical properties and a semiconductor device including the silicone-based resin composition.

[Technical Solution]

In accordance with an aspect of the present invention, the above and other objects can be accomplished by the provision of a silicone-based resin composition, according to claim 1, including: an organic polysiloxane; and a conductive filler, wherein a relative ratio of a change in thermal conductivity to a change in Shore A hardness, measured by a measurement method below, of the silicone-based resin composition is 40% or less:

[Measurement method]

1) The silicone-based resin composition is molded by hot press under conditions of 165°C and a pressure of 26 $kgf/cm^2$ for 15 minutes to manufacture a sheet.
2) The sheet is cured at 150°C for 5 minutes to manufacture a first cured product. The first cured product is subjected to measurement of a Shore A hardness according to ASTM D-2240 and measurement of a thermal conductivity according to ISO 22007-2 at 25°C.
3) The first cured product is cured at 150°C for 120 minutes to manufacture a second cured product. The second cured product is subjected to measurement of a Shore A hardness according to ASTM D-2240 and measurement of a thermal conductivity according to ISO 22007-2 at 25°C temperature.
4) A relative ratio of a change in thermal conductivity to a change in Shore A hardness is calculated according to Equation 1 below:

[Equation 1]

$$[(\left| TC_{H2} - TC_{H1} \right|) / (H2\text{-}H1)] \times 100$$

(where H1 denotes the Shore A hardness of the first cured product, H2 denotes the Shore A hardness of the second cured product, $TC_{H1}$ denotes a thermal conductivity (W/mK) in H1, and TCH2 denotes a thermal conductivity (W/mK) in H2.).

In an embodiment of the present invention, the silicone-based resin composition may have a thermal conductivity change rate of 30% or less calculated according to Equation 2 below:

[Equation 2]

$$(\left| TC_{H2} - TC_{H1} \right| / TC_{H2}) \times 100$$

(where TCH1 and TCH2 are as defined in Equation 1 above.).

In an embodiment of the present invention, a cured product of the silicone-based resin composition may have a Shore A hardness of 95 or less according to ASTM D-2240.

In an embodiment of the present invention, the silicone-based resin composition may satisfy Equation 3 below:

[Equation 3]

$$Y = 0.0169X + 6.5193$$

(where X denotes a Shore A hardness according to ASTM D-2240 in a cured product of the silicone-based resin composition, Y denotes a thermal conductivity according to ISO 22007-2 at 25°C of a cured product of the silicone-based resin composition, and Y is 6 W/mK to 8 W/mK.).

In an embodiment of the present invention, X may be in a range of 3 to 57, a coefficient of determination ($R^2$) is 0.95 or more.

In an embodiment of the present invention, the conductive filler may include a conductive powder that includes

flake-type particles having a thickness of 0.01 $\mu$m to 5 $\mu$m.

In an embodiment of the present invention, the conductive powder may have a specific surface area of 0.1 $m^2$/g to 1.5 $m^2$/g.

In an embodiment of the present invention, the conductive powder may have an average particle diameter ($D_{50}$) of 1.0 $\mu$m to 20.0 $\mu$m.

In an embodiment of the present invention, an ignition loss of the conductive powder may be 0.4 % by weight or less.

In accordance with another aspect of the present invention, there is provided a semiconductor device, including: a semiconductor package; a heat dissipation part disposed on the semiconductor package; and a heat conduction layer interposed between the semiconductor package and the heat dissipation part, wherein the heat conduction layer includes a silicone-based resin composition, the silicone-based resin composition includes organic polysiloxane and a conductive filler, and a relative ratio of a change in thermal conductivity to a change in Shore A hardness, measured by a measurement method below, of the silicone-based resin composition is 40% or less:

[Measurement method]

1) The silicone-based resin composition is molded by hot press under conditions of 165°C and a pressure of 26 kgf/$cm^2$ for 15 minutes to manufacture a sheet.
2) The sheet is cured at 150°C for 5 minutes to manufacture a first cured product. The first cured product is subjected to measurement of a Shore A hardness according to ASTM D-2240 and measurement of a thermal conductivity according to ISO 22007-2 at 25°C.
3) The first cured product is cured at 150°C for 120 minutes to manufacture a second cured product. The second cured product is subjected to measurement of a Shore A hardness according to ASTM D-2240 and measurement of a thermal conductivity according to ISO 22007-2 at 25°C temperature.
4) A relative ratio of a change in thermal conductivity to a change in Shore A hardness is calculated according to Equation 1 below:

[Equation 1]

$$[(\left| TC_{H2} - TC_{H1} \right|) / (H2\text{-}H1)] \times 100$$

(where H1 denotes the Shore A hardness of the first cured product, H2 denotes the Shore A hardness of the second cured product, $TC_{H1}$ denotes a thermal conductivity (W/mK) in H1, and TCH2 denotes a thermal conductivity (W/mK) in H2.).

[Advantageous effects]

A silicone-based resin composition according to the present invention exhibits a thermal conductivity value capable of performing an appropriate heat dissipation function even when a variation in hardness occurs, and can improve the reliability of product performance due to a small variation in thermal conductivity.

In addition, the silicone-based resin composition according to the present invention includes conductive particles having a relatively thin flake shape, so that an empty space between conductive filler particles can be reduced and, accordingly, the deformation of the arrangement of the conductive filler during a curing process can be alleviated, whereby a change in thermal conductivity caused by a change in hardness can be reduced.

Further, the silicone-based resin composition according to the present invention can exhibit a relatively high thermal conductivity with only a low content of conductive filler, thereby being capable of improving adhesion reliability and moldability, compared to a silicone-based resin composition including a high content of conductive filler.

[Description of Drawings]

FIG. 1 sequentially illustrates a method of measuring the Shore A hardness and thermal conductivity of a silicone-based resin composition according to the present invention.
FIG. 2 schematically illustrates a semiconductor device according to the present invention.

[Best mode]

Structural or functional descriptions of the embodiments disclosed in this specification or application are merely exemplified for the purpose of explaining embodiments according to the technical idea of the present invention, embodiments according to the technical idea of the present invention may be implemented in various forms other than the embodiments disclosed in this specification or application, and it is not to be construed that the technical idea of the present invention is limited to the embodiments described in this specification or application.
In addition, when a component is "included" or "comprised" in this specification or application, other components may be further included or comprised, rather than excluding other components, unless otherwise stated. In addition, it should be understood that all numerical ranges representing the physical property values, dimensions, etc. of components described in this specification or application are modified by the term "about" in all cases unless otherwise specified.
Hereinafter, a silicone-based resin composition according to the present invention and a semiconductor device including the silicone-based resin composition are described.

<Silicone-based resin composition>

The silicone-based resin composition according to the present invention includes an organic polysiloxane and a conductive filler, and a relative ratio of a change in thermal conductivity to a change in Shore A hardness, as measured by the following measurement method, of the silicone-based resin composition is 40% or less:

[Measurement method]

1) The silicone-based resin composition is molded by hot press under conditions of 165°C and a pressure of 26 kgf/cm$^2$ for 15 minutes to manufacture a sheet.
2) The sheet is cured at 150°C for 5 minutes to manufacture a first cured product. The first cured product is subjected to measurement of a Shore A hardness according to ASTM D-2240 and measurement of a thermal conductivity according to ISO 22007-2 at 25°C.
3) The first cured product is cured at 150°C for 120 minutes to manufacture a second cured product. The second cured product is subjected to measurement of a Shore A hardness according to ASTM D-2240 and measurement of a thermal conductivity according to ISO 22007-2 at 25°C temperature.
4) A relative ratio of a change in thermal conductivity to a change in Shore A hardness is calculated according to Equation 1 below:

[Equation 1]

$$[( | TC_{H2} - TC_{H1} | ) / (H2\text{-}H1)] \times 100$$

(where H1 denotes the Shore A hardness of the first cured product, H2 denotes the Shore A hardness of the second cured product, $TC_{H1}$ denotes a thermal conductivity (W/mK) in H1, and TCH2 denotes a thermal conductivity (W/mK) in H2.).

The silicone-based resin composition includes an organic polysiloxane.
The organic polysiloxane may be represented by Formula 1 below:

[Formula 1] $R^1{}_aSiO_b$

where $R^1$ represents one or two or more groups selected from the group consisting of a hydrogen atom, a hydroxyl group, and a saturated or unsaturated monovalent hydrocarbon group having 1 to 18 carbon atoms and a may be about 1.8 to about 2.2. a+b may be about 3.5 to about 8.
a+b may be 4.
In Formula 1, the saturated or unsaturated monovalent hydrocarbon group having 1 to 18 carbon atoms represented by $R^1$ may be, for example, an alkyl group such as a methyl group, an ethyl group, a propyl group, a hexyl group, an octyl group, a decyl group, a dodecyl group, a tetradecyl group, a hexadecyl group, or an octadecyl group; a cycloalkyl group such as a cyclopentyl group or a cyclohexyl group; an alkenyl group such as a vinyl group or an allyl group; an aryl group such as a phenyl group or a tolyl group; an aralkyl group such as a 2-phenylethyl group or a 2-methyl-2-phenylethyl group; or a halogenated hydrocarbon group such as a 3,3,3-trifluoropropyl group, a 2-(perfluorobutyl)ethyl group, a 2-(perfluorooctyl)ethyl group, or a p-chlorophenyl group.

The organic polysiloxane may have a weight average molecular weight of about 40,000 g/mol to about 80,000 g/mol, about 30,000 g/mol to about 100,000 g/mol, about 500 g/mol to about 10,000 g/mol, about 700 g/mol to about 7,000 g/mol, about 1,000 g/mol to about 5,000 g/mol, or about 1,500 g/mol to about 3,000 g/mol. The weight average molecular weight may be measured based on polystyrene.

In the organic polysiloxane, a kinematic viscosity at 25°C may be 10 $mm^2/s$ to 100,000 $mm^2/s$, 20,000 $mm^2/s$ to 100,000 $mm^2/s$, or about 30 $mm^2/s$ to about 10,000 $mm^2/s$. The kinematic viscosity of the organic polysiloxane may be a value at 25°C measured with an Ostwald viscometer.

When the organic polysiloxane has a weight average molecular weight and kinematic viscosity within the above ranges, proper bonding strength to an adherend may be maintained, and durability may be improved because voids and cracks due to thermal shock do not occur.

The organic polysiloxane may include a first organic polysiloxane.

The first organic polysiloxane includes an alkenyl group bonded to a silicon atom, and the number of the alkenyl groups present in one molecule of the first organic polysiloxane may be at least two, two to ten, two to five, or two.

The first organic polysiloxane may be represented by Formula 2 below:

[Formula 2] $R^1_aR^2_cSiO_b$

where $R^1$ may be a hydrogen atom, a hydroxyl group, or a saturated or unsaturated monovalent hydrocarbon group having 1 to 18 carbon atoms, and $R^2$ may be an alkenyl group. In Formula 2, a+c may be about 1.8 to about 2.2, and a+b+c may be about 3.5 to about 8. In Formula 2, a+b+c may be about 4. In Formula 2, a may be about 1.8 to about 2.2. In addition, c may be 0.0001 to 0.1.

The first organic polysiloxane may be represented by Formula 3 below:

[Formula 3]

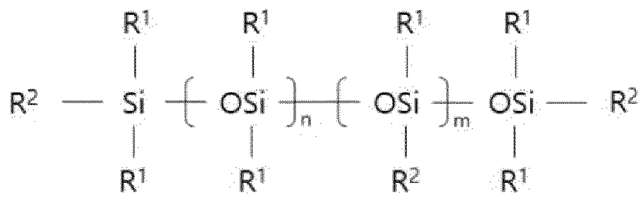

where $R^1$ may be a hydrogen atom, a hydroxyl group, or a saturated or unsaturated monovalent hydrocarbon group having 1 to 18 carbon atoms, $R^2$ may be an alkenyl group. In addition, in Formula 3, n may be 1 to 1,500, and m may be 0 to 20. In Formula 3, n may be 10 to 1,000, and m may be 0 to 20.

The first organic polysiloxane may be represented by Formula 4 below:

[Formula 4]

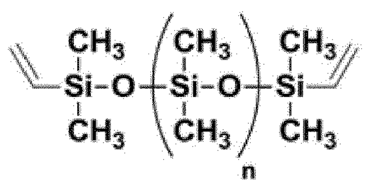

where n may be 1 to 1,500. n may be 10 to 1,000.

The first organic polysiloxane may have a weight average molecular weight (Mw) of about 500 g/mol to about 10,000 g/mol, about 700 g/mol to about 7,000 g/mol, about 1,000 g/mol to about 5,000 g/mol, or about 1,500 g/mol to about 3,000 g/mol. The weight average molecular weight may be measured based on polystyrene.

In the first organic polysiloxane, a kinematic viscosity at 23°C may be 10 cPs to 100,000 cPs, 30 cPs to 50,000 cPs, or 10,000 cPs to 40,000 cPs. The kinematic viscosity of the first organic polysiloxane may be a value at 25°C measured with an Ostwald viscometer.

The organic polysiloxane may include a second organic polysiloxane.

The second organic polysiloxane may include a hydrogen group bonded to a silicon atom. The number of the hydrogen groups per molecule of the second organic polysiloxane may be 1 to 10, 2 to 10, 2 to 5, or 2.

The second organic polysiloxane may be represented by Formula 5 below:

[Formula 5]

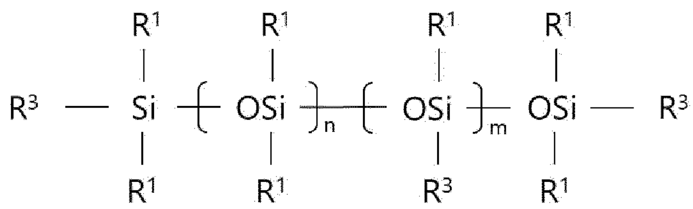

where $R^1$ may be a hydrogen atom, a hydroxyl group, or a saturated or unsaturated monovalent hydrocarbon group having 1 to 18 carbon atoms, and $R^3$ may be a hydrogen atom. In addition, in Formula 5, n may be 1 to 1,500, and m may be 0 to 20. In Formula 5, n may be 10 to 1,000, and m may be 0 to 20. In Formula 5, n may be 1 to 1,500, and m may be 0.

The second organic polysiloxane may be represented by Formula 6 below:

[Formula 6]

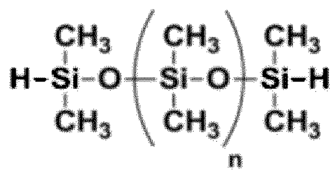

At about 23°C, the second organic polysiloxane may have a viscosity of about 500 cPs to about 5,000 cPs, about 500 cPs to about 3,000 cPs, or about 500 cPs to about 2,000 cPs.

The organic polysiloxane may further include a third organic polysiloxane. The third organic polysiloxane may be represented by Formula 7 below:

[Formula 7]

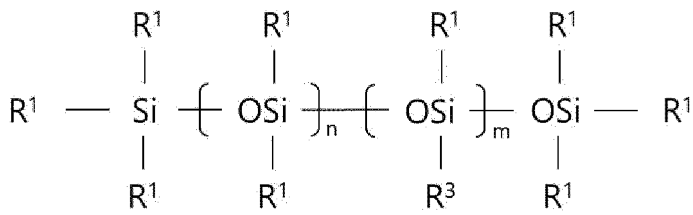

where $R^1$ may be a hydrogen atom, a hydroxyl group, or a saturated or unsaturated monovalent hydrocarbon group having 1 to 18 carbon atoms, $R^3$ may be a hydrogen atom. In addition, in Formula 7, n may be 1 to 1,500 and m may be 1 to 500. In Formula 7, n may be 10 to 1,000 and m may be 1 to 100.

The third organic polysiloxane may be represented by Formula 8 below:

[Formula 8]

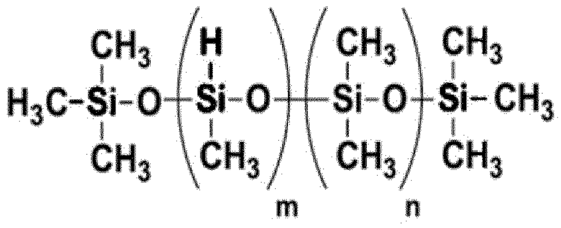

where n may be 1 to 1,500 and m may be 1 to 500. In Formula 8, n may be 10 to 1,000 and m may be 1 to 100.

At about 23°C, the third organic polysiloxane may have a viscosity of about 50 cPs to about 1,000 cPs, about 100 cPs to about 500 cPs, or about 100 cPs to about 500 cPs.

A ratio of the viscosity of the first organic polysiloxane to the viscosity of the second organic polysiloxane may be 10:1 to 40:1.

In addition, a ratio of the viscosity of the second organic polysiloxane to the viscosity of the third organic polysiloxane may be 2:1 to 10:1.

The content of the first organic polysiloxane may be about 60 parts by weight to about 90 parts by weight, about 70 parts by weight to about 85 parts by weight, or about 75 parts by weight to about 85 parts by weight based on 100 parts by weight of the total organic polysiloxane.

The content of the second organic polysiloxane may be about 10 parts by weight to about 40 parts by weight, about 10 parts by weight to about 30 parts by weight, or about 12 parts by weight to about 23 parts by weight based on 100 parts by weight of the first organic polysiloxane.

The content of the third organic polysiloxane may be about 3 parts by weight to about 20 parts by weight, about 3 parts by weight to about 15 parts by weight, or about 4 parts by weight to about 10 parts by weight based on 100 parts by weight of the first organic polysiloxane.

When the silicone-based resin composition includes the first organic polysiloxane, the second organic polysiloxane and the third organic polysiloxane within the above ranges, proper adhesion to an adherend may be maintained and the silicone-based resin composition may evenly spread during a coating process.

The silicone-based resin composition includes a conductive filler.

The conductive filler may include a conductive powder including flake-type particles. The conductive powder may include flake-type silver particles.

The conductive filler may include a conductive powder including flake-type particles with a thickness of 0.01 $\mu$m to 5 $\mu$m, 0.01 $\mu$m to 4 $\mu$m, 0.01 $\mu$m to 3 $\mu$m, or 0.01 $\mu$m to 2 $\mu$m. Due to inclusion of flake-type particles within this thickness range, an empty space between the conductive filler particles is reduced, so that the deformation phenomenon of the arrangement of the conductive filler during the curing process is alleviated, thereby reducing thermal conductivity variation caused by variations in hardness.

The conductive powder may have a tap density of 0.1 g/cm$^3$ to 10.0 g/cm$^3$, 1.0 g/cm$^3$ to 8.0 g/cm$^3$, 2.0 g/cm$^3$ to 8.0 g/cm$^3$, 3.0 g/cm$^3$ to 8.0 g/cm$^3$, 4.0 g/cm$^3$ to 8.0 g/cm$^3$, or 4.0 g/cm$^3$ to 7.0 g/cm$^3$.

The tap density is calculated from the volume of a silver powder obtained by weighing 100 g of silver powder and dropping it lightly into a 100 ml measuring cylinder with a funnel, followed by placing the cylinder on a tap density meter and dropping it 600 times at a speed of 60 times/min at a drop distance of 20 mm to be compressed.

The conductive powder may have an average particle diameter ($D_{50}$) of about 0.5 $\mu$m to about 20 $\mu$m, about 1 $\mu$m to about 20 $\mu$m, about 1 $\mu$m to about 15 $\mu$m, about 1 $\mu$m to about 10 $\mu$m, about 1 $\mu$m to about 5 $\mu$m, or about 1.5 $\mu$m to about 2.5 $\mu$m.

The average particle diameter ($D_{50}$) is defined as a particle diameter corresponding to 50% of a cumulative volume in a particle diameter distribution curve of silver powder derived using a laser diffraction method.

The conductive powder may have a specific surface area of 0.1 m$^2$/g to 3.0 m$^2$/g, 0.1 m$^2$/g to 2.0 m$^2$/g, 0.1 m$^2$/g to 1.8 m$^2$/g, 0.1 m$^2$/g to 1.5 m$^2$/g, 0.1 m$^2$/g to 1.0 m$^2$/g, 0.1 m$^2$/g to 0.9 m$^2$/g, 0.1 m$^2$/g to 0.8 m$^2$/g, or 0.1 m$^2$/g to 0.7 m$^2$/g.

The specific surface area is determined by taking about 2 g of silver powder as a sample and degassing at 60 $\pm$ 5 °C for 10 minutes, followed by measuring a total surface area with an automatic specific surface area measurement device (BET method), weighing a sample amount, and calculating according to the following equation.

$$\text{Specific surface area } (m^2/g) = \text{Total surface area } (m^2)/\text{sample amount } (g)$$

The flake-type particles included in the conductive powder may have an aspect ratio of about 2 to 30, about 2 to

25, about 2 to 20, or about 2 to 18.

The conductive powder may be surface-treated with a surface treatment agent. The surface treatment agent may include a C10 to C20 fatty acid. Examples of the fatty acids include capric acid, lauric acid, myristic acid, palmitic acid, stearic acid, arachidic acid, myristoleic acid, palmitoleic acid, sapienic acid, oleic acid, elaidic acid, vaccenic acid, linoleic acid, lionelidic acid, arichidonic acid, eicosapentaenoic acid, $\alpha$-linolenic acid, and the like.

The conductive powder may have an ignition loss (Ig-loss) of less than about 0.8 % by weight, less than about 0.7 % by weight, less than about 0.6 % by weight, less than about 0.5 % by weight, less than about 0.4 % by weight, less than about 0.3 % by weight, less than about 0.2 % by weight, or about 0.01 % by weight or more to less than about 0.4 % by weight. The ignition loss may be performed and measured at about 538°C for about 1 hour.

The conductive powder may be effectively surface-treated even with a small amount of the surface treatment agent. That is, the conductive powder has a relatively low tap density and a large specific surface area and may be surface-treated even with a small amount of the surface treatment agent. Accordingly, the conductive powder may improve thermal connection of the conductive filler while being uniformly dispersed in the organic polysiloxane. That is, since the conductive powder has improved dispersibility, it may be added in a high content to the organic polysiloxane. **In** addition, since the conductive powder has a flake-like surface area and a coating layer formed by the surface treatment agent is thin, contact characteristics between conductive fillers may be improved. Accordingly, the conductive powder may improve the thermal conductivity of the silicone-based resin composition.

The silicone-based resin composition may include the first silver powder in a content of about 300 parts by weight to about 1,000 parts by weight, about 400 parts by weight to about 900 parts by weight, or about 500 parts by weight to about 800 parts by weight based on 100 parts by weight of the organic polysiloxane.

The conductive powder may further include dendrite-type silver particles or spherical silver particles.

Since the conductive filler includes flake-type silver particles and dendrite-type silver particles or spherical silver particles having a shape different from the flake-type silver particles, the formation of an electrical network between the particles may be improved, so that a thermal conductivity may be improved.

The silicone-based resin composition may include the organic polysiloxane and the conductive filler in a weight ratio of 20:80 to 5:95, 20:80 to 6:94, or 20:80 to 10:90. When the range is satisfied, proper adhesion to an adherend may be maintained, and durability may be improved because voids and cracks due to thermal shock do not occur.

In the silicone-based resin composition according to the present invention, a relative ratio of a change in thermal conductivity to a change in Shore A hardness measured by the following measurement method is 40% or less:

[Measurement method]

1) The silicone-based resin composition is molded by hot press under conditions of 165°C and a pressure of 26 $kgf/cm^2$ for 15 minutes to manufacture a sheet.
2) The sheet is cured at 150°C for 5 minutes to manufacture a first cured product. The first cured product is subjected to measurement of a Shore A hardness according to ASTM D-2240 and measurement of a thermal conductivity according to ISO 22007-2 at 25°C.
3) The first cured product is cured at 150°C for 120 minutes to manufacture a second cured product. The second cured product is subjected to measurement of a Shore A hardness according to ASTM D-2240 and measurement of a thermal conductivity according to ISO 22007-2 at 25°C temperature.
4) A relative ratio of a change in thermal conductivity to a change in Shore A hardness is calculated according to Equation 1 below:

[Equation 1]

$$[(\left| TC_{H2} - TC_{H1} \right|) / (H2\text{-}H1)] \times 100$$

(where H1 denotes the Shore A hardness of the first cured product, H2 denotes the Shore A hardness of the second cured product, $TC_{H1}$ denotes a thermal conductivity (W/mK) in H1, and TCH2 denotes a thermal conductivity (W/mK) in H2.).

FIG. 1 sequentially illustrates a method of measuring the Shore A hardness and thermal conductivity of the silicone-based resin composition according to the present invention.

Referring to FIG. 1, (a) a silicone-based resin composition 10 is fed into a mold 20, and then the silicone-based resin composition 10 is molded by hot press under conditions of 165°C and a pressure of 26 $kgf/cm^2$ for 15 minutes to

manufacture a sheet 11.

Next, (b) the sheet 11 is cured at 150°C for 5 minutes to manufacture a first cured product 11-1.

Next, (c) the first cured product 11-1 is subjected to measurement of a Shore A hardness according to ASTM D-2240 and measurement of a thermal conductivity according to ISO 22007-2 at 25°C temperature.

Next, (d) the first cured product 11-1 is cured at 150°C for 120 minutes to manufacture a second cured product 11-2.

Next, (e) the second cured product 11-2 is subjected to measurement of a Shore A hardness according to ASTM D-2240 and measurement of a thermal conductivity according to ISO 22007-2 at 25°C temperature.

The sheet 11 and the first cured product 11-1 may be fed into the dry oven 30 and cured therein.

Next, the hardness and thermal conductivity measurement values of the first cured product 11-1 and the hardness and thermal conductivity measurement values of the second cured product 11-2 are substituted into Equation 1 to calculate a relative ratio of a change in thermal conductivity of the first cured product 11-1 and the second cured product 11-2 relative to a change in Shore A hardness of the first cured product 11-1 and the second cured product 11-2.

In the silicone-based resin composition, a relative ratio of a change in thermal conductivity to a change in Shore A hardness measured by the measurement method may be 35% or less, 30% or less, 25% or less, 20% or less, 10% or less, 5% or less, or 1% or less.

The silicone-based resin composition may have a thermal conductivity change rate of 30% or less calculated according to Equation 2 below:

[Equation 2]

$$(\left| TC_{H2} - TC_{H1} \right| / TC_{H2}) \times 100$$

(where TCH1 and TCH2 are as defined in Equation 1 above.).

The silicone-based resin composition may have a thermal conductivity change rate of 25% or less, 20% or less, 15% or less, 13% or less, 10% or less, 5% or less, 3% or less, or 1.5% or less.

In general, in the case of a silicone-based resin composition, a variation in hardness of products manufactured from the silicone-based resin composition may occur depending upon a curing temperature, a curing time, or the composition of the silicone-based resin composition. In addition, since a variation in thermal conductivity occurs due to a variation in product hardness, there is a problem when applying a product that needs to perform a heat dissipation function.

Accordingly, since a relative ratio of a change in thermal conductivity to a change in Shore A hardness, measured by the measurement method, of the silicone-based resin composition according to the present invention is 40% or less, a change in thermal conductivity compared to a change in hardness is significantly reduced, a thermal conductivity value capable of performing an appropriate heat dissipation function is exhibited, and reliability may be improved when applying a product that needs to perform a heat dissipation function due to a small thermal conductivity variation even if a variation occurs in hardness of a product manufactured from the silicone-based resin composition.

In addition, since the silicone-based resin composition according to the present invention may exhibit a relatively high thermal conductivity with only a low content of conductive filler, adhesion reliability and moldability may be improved compared to a silicone-based resin composition including a high content of conductive filler.

A Shore A hardness according to ASTM D-2240 of a cured product of the silicone-based resin composition may be 95 or less, 85 or less, 75 or less, 65 or less, 60 or less, 10 to 60 or less, 20 to 60 or less, or 30 to 60 or less. When the hardness is within the range, the occurrence of abrasion or cracking during product manufacturing may be minimized.

The silicone-based resin composition may satisfy Equation 3 below:

[Equation 3]

$$Y = 0.0169X + 6.5193$$

(where X denotes a Shore A hardness according to ASTM D-2240 in a cured product of the silicone-based resin composition, Y denotes a thermal conductivity according to ISO 22007-2 at 25°C of a cured product of the silicone-based resin composition, and Y is 6 W/mK to 8 W/mK.)

A coefficient of determination ($R^2$) of X in a range of 3 to 57 may be 0.95 or more.

Equation 3 denotes a linear trend line with a Shore A hardness as an X variable and a thermal conductivity, which is a dependent variable according to the X variable, as Y. The linear trend line may be derived using Microsoft's Excel program, and a coefficient of determination ($R^2$) may be obtained from the linear trend line. The coefficient of determination, which is a statistical term, is a measure of the goodness of fit of a well-known regression equation and represents a ratio of the sum of fluctuations to the total sum of fluctuations of $Y_i$ with respect to data $Y_i$ of a dependent variable Y. The coefficient of determination is generally represented by $R^2$, and the goodness of fit of the regression equation increases as the coefficient of determination approaches 1.

For example, in Equation 3, Y is 6.6 to 7.4 in a range where X is 3 to 57, which means that a thermal conductivity in a range where the Shore A hardness is 3 to 57 is 6.6 W/mK to 7.4 W/mK. Here, the coefficient of determination ($R^2$) represents 0.95 or more. Accordingly, even if a variation of hardness is large, a variation of thermal conductivity is not relatively large, which may indicate that the goodness of fit of the regression equation is high. Therefore, the silicone-based resin composition that satisfies Equation 3 may satisfy the reliability of product performance due to a small variation in thermal conductivity even if there is a variation in hardness.

The silicone-based resin composition may further include a tackifier.

The tackifier may include alkoxysilane. In addition, the tackifier may include an epoxy group. The tackifier may be at least one selected from the group consisting of 2-(3,4 epoxycyclohexyl) ethyltrimethoxysilane, 3-glycidoxypropyl methyldimethoxysilane, 3-glycidoxypropyl trimethoxysilane, 3-glycidoxypropyl methyldiethoxysilane, and 3-glycidoxypropyl triethoxysilane.

The silicone-based resin composition may include the tackifier in a content of about 1 part by weight to about 20 parts by weight, about 1 part by weight to about 10 parts by weight, or about 2 parts by weight to about 8 parts by weight based on 100 parts by weight of the organic polysiloxane. The tackifier may improve adhesive strength between the organic polysiloxane and the conductive filler.

The silicone-based resin composition may further include a curing catalyst. The curing catalyst may accelerate curing of the silicone-based resin composition.

The curing catalyst may include a platinum-based catalyst.

Examples of the curing catalyst include organic titanate esters such as platinum-divinyltetramethyldisiloxane complex, tetrabutyl titanate, and tetraisopropyl titanate; organic titanium chelate compounds such as diisopropoxybis(acetylacetate)titanium and diisopropoxybis(ethylacetoacetate)titanium; organoaluminum compounds such as aluminum tris(acetylacetonate) and aluminum tris(ethylacetoacetate); organic zirconium compounds such as zirconium tetra(acetylacetonate) and zirconium tetrabutylate; organic tin compounds such as dibutyltin dioctoate, dibutyltin dilaurate, and butyltin-2-ethylhexoate; metal salts of organic carboxylic acids such as tin naphthenate, tin oleate, tin butyrate, cobalt naphthenate, and zinc stearate; amine compounds such as hexylamine and dodecylamine phosphate and salts thereof; quaternary ammonium salts such as benzyltriethylammonium acetate; lower fatty acid salts of alkali metals such as potassium acetate; dialkyl hydroxylamines such as dimethylhydroxylamine and diethylhydroxylamine; and guanidyl group-containing organosilicon compounds.

The silicone-based resin composition may include the curing catalyst in a content of about 0.01 parts by weight to about 5 parts by weight, about 0.03 parts by weight to about 3 parts by weight, or about 0.1 parts by weight to about 2 parts by weight based on 100 parts by weight of the organic polysiloxane.

The silicone-based resin composition may further include a reaction inhibitor. The reaction inhibitor may be at least one selected from the group consisting of acetylenic compounds such as 2-methyl-3-butyn-2-ol, 2-phenyl-3-butyn-2-ol, and 1-ethynyl-1-cyclohexanol; ene-yne compounds such as 3-methyl-3-penten-1-yne and 3,5-dimethyl-3-hexen-1-yne; curing reaction inhibitors such as hydrazine-based compounds, phosphine-based compounds, and mercaptan-based compound; and the like.

The silicone-based resin composition may include the reaction inhibitor in a content of about 0.0001 parts by weight to about 10 parts by weight based on 100 parts by weight of the organic polysiloxane.

<Method of preparing silicone-based resin composition>

A method of preparing the silicone-based resin composition may be a known preparation method, without being specifically limited.

For example, the silicone-based resin composition may be prepared by mixing the organic polysiloxane, the conductive filler, the tackifier, the curing catalyst, the curing reaction inhibitor, and the like for 30 minutes to 4 hours using a mixer such as Trimix, Twinmix, and a planetary mixer (all of which are manufactured by Inoue Seisakusho Co., Ltd., registered trademark); Ultramixer (manufactured by Mizuho Kogyo Co., Ltd., registered trademark); or Hibis Disper Mix (manufactured by Primix Co., Ltd., registered trademark). In the mixing process, a process temperature may be about 0°C to about 25°C.

<Semiconductor device>

FIG. 2 schematically illustrates the semiconductor device according to the present invention.

Referring to FIG. 2, the semiconductor device may include a circuit board 100, a semiconductor package 200, a

conductive bumps 300, a heat dissipation part 400 and a heat conduction layer 500.

The semiconductor device according to the present invention includes the semiconductor package 200, the heat dissipation part 400 disposed on the semiconductor package 200, and the heat conduction layer 500 interposed between the semiconductor package 200 and the heat dissipation part 400, the heat conduction layer 500 includes a silicone-based resin composition, the silicone-based resin composition includes an organic polysiloxane and a conductive filler, and a relative ratio of a change in thermal conductivity to a change in Shore A hardness, measured by the following measurement method, of the silicone-based resin composition is 40% or less:

[Measurement method]

1) The silicone-based resin composition is molded by hot press under conditions of 165°C and a pressure of 26 kgf/cm$^2$ for 15 minutes to manufacture a sheet.
2) The sheet is cured at 150°C for 5 minutes to manufacture a first cured product. The first cured product is subjected to measurement of a Shore A hardness according to ASTM D-2240 and measurement of a thermal conductivity according to ISO 22007-2 at 25°C.
3) The first cured product is cured at 150°C for 120 minutes to manufacture a second cured product. The second cured product is subjected to measurement of a Shore A hardness according to ASTM D-2240 and measurement of a thermal conductivity according to ISO 22007-2 at 25°C temperature.
4) A relative ratio of a change in thermal conductivity to a change in Shore A hardness is calculated according to Equation 1 below:

[Equation 1]

$$[(\left| TC_{H2} - TC_{H1} \right|) / (H2\text{-}H1)] \times 100$$

(where H1 denotes the Shore A hardness of the first cured product, H2 denotes the Shore A hardness of the second cured product, $TC_{H1}$ denotes a thermal conductivity (W/mK) in H1, and TCH2 denotes a thermal conductivity (W/mK) in H2.).

A specific method of measuring the hardness and thermal conductivity of the silicone-based resin composition is the same as shown in FIG. 1.

Since a relative ratio of a change in thermal conductivity to a change in Shore A hardness of the silicone-based resin composition is 40% or less, the heat conduction layer 500 including the silicone-based resin composition has a small thermal conductivity variation, so that reliability of product performance may be secured. In addition, the heat conduction layer 500 may maintain proper adhesion to the semiconductor package 200 and the heat dissipation part 400.

The circuit board 100 may support the semiconductor package 200, the conductive bumps 300, the heat dissipation part 400 and the heat conduction layer 500.

The circuit board 100 may include a circuit pattern. The circuit board 100 may include a plurality of circuit patterns disposed inside a flat body including an insulating and heat-resistant material and having a predetermined strength. In addition, the circuit board 100 may include a connection pad electrically connected to the circuit pattern and disposed on the body.

For example, the body of the circuit board 100 may include a thermosetting resin-based substrate such as an epoxy resin substrate or a polyimide substrate, a flat plate, or a flat plate attached with a heat-resistant organic film such as a liquid crystal polyester film or a polyamide film. The circuit pattern may be disposed inside the body in a pattern shape and may include power wiring for power supply, ground wiring, and signal wiring for signal transmission. Each wiring may be disposed to be separated from each other by a plurality of interlayer insulating films formed on upper and lower surfaces of the body.

The connection pad may be exposed to the outside from the upper surface of the body and may be connected to the circuit pattern. Therefore, an external connection body connected to the circuit board 100 may be electrically connected to an internal circuit pattern through the connection pad.

Various electronic components may be mounted on a connection pad included in the circuit board 100. That is, the circuit board 100 may be a system board on which electronic components including the semiconductor package 200 are mounted.

The semiconductor package 200 may be mounted on the circuit board 100. The semiconductor package 200 may be disposed on the circuit board 100. The semiconductor package 200 may be connected to the circuit board 100

through the conductive bumps 300.

The semiconductor package 200 may include a semiconductor chip including an integrated circuit, a semiconductor package substrate connected to the semiconductor chip, a conductive solder for connecting the semiconductor chip and the semiconductor package substrate, and a sealing part for sealing the semiconductor chip and the conductive solder. The sealing part may include a resin composition such as epoxy molding.

The semiconductor package 200 may be a memory device, a central processing unit, or the like.

The conductive bumps 300 may be disposed between the semiconductor package 200 and the circuit board 100. The conductive bumps 300 may electrically connect the semiconductor package 200 and the circuit board 100 to each other. The conductive bumps 300 may be electrically connected to the semiconductor package 200 and the connection pad.

The heat dissipation part 400 may be disposed on the semiconductor package 200. The heat dissipation part 400 may cover the semiconductor package 200. The heat dissipation part 400 may be bonded to the circuit board 100. The heat dissipation part 400 may cover a side surface of the semiconductor package 200.

The heat dissipation part 400 may include a conductor. The heat dissipation part 400 may include metal. The heat dissipation part 400 may be thermally connected to an external heat dissipation fin.

**In** addition, the heat dissipation part 400 may protect the semiconductor package 200 against external physical impact. The heat dissipation part 400 may protect the semiconductor package 200 against external electromagnetic waves. That is, the heat dissipation part 400 may block external electromagnetic waves.

The heat conduction layer 500 may be disposed between the semiconductor package 200 and the heat dissipation part 400. The heat conduction layer 500 may directly contact the semiconductor package 200 and the heat dissipation part 400. The heat conduction layer 500 may be in close contact between the semiconductor package 200 and the heat dissipation part 400.

The heat conduction layer 500 may be thermally connected to the semiconductor package 200 and the heat dissipation part 400. That is, the heat conduction layer 500 may transfer heat generated from the semiconductor package 200 to the heat dissipation part 400.

The thickness of the heat conduction layer 500 may be about 1 $\mu$m to about 100 $\mu$m, about 2 $\mu$m to about 70 $\mu$m, about 5 $\mu$m to about 60 $\mu$m, or about 10 $\mu$m to about 40 $\mu$m.

<Method of manufacturing semiconductor device >

A method of manufacturing the semiconductor device may be a known manufacturing method, without being specifically limited.

First, the semiconductor package 200 may be mounted on the circuit board 100 by the conductive bumps 300. Next, the silicone-based resin composition may be coated on the semiconductor package 200. Alternatively, the silicone-based resin composition may be coated on a lower surface of the heat dissipation part 400.

Next, the heat dissipation part 400 may cover the semiconductor package 200. Accordingly, the coated silicone-based resin composition may be in direct contact with the lower surface of the heat dissipation part 400 and the upper surface of the semiconductor package 200, and the curable silicone resin composition may be cured at about 80°C or more in a state in which a pressure of about 0.01 MPa or more is applied.

A pressure in the curing process may be about 0.01 MPa or more. The pressure in the curing process may be about 0.05 MPa to about 100 MPa. The pressure in the curing process may be about 0.1 MPa to about 100 MPa.

A temperature in the curing process may be about 110°C to about 300°C. The temperature in the curing process may be about 120°C to about 300°C. The temperature in the curing process may be about 140°C to about 300°C. A curing time in the curing process may be about 30 minutes to about 5 hours. The heat conduction layer 500 may be formed by the process.

Hereinafter, the present invention is described in more detail based on Examples and Comparative Examples. However, the following Examples and Comparative Examples are only examples for explaining the present invention in more detail, and the present invention is not limited by the following Examples and Comparative Examples.

## Example

- Organic polysiloxane #1: Compound represented by the above Formula 4 having a viscosity of 20,000 cPs at 23°C and including a silicon-bonded alkenyl group
- Organic polysiloxane #2: Compound represented by the above Formula 6 having a viscosity of 1,000 cPs at 23°C and including a structure in which hydrogen groups are bonded to both ends thereof
- Organic polysiloxane #3: Compound represented by the above Formula 8 having a viscosity of 1,000 cPs at 23°C and

including a structure in which a hydrogen group is bonded to a side chain thereof

- Conductive filler #1: Flake-type silver powder having a tap density of about 5.0 g/$cm^3$, a specific surface area of about 0.42 $m^2$/g, an average particle diameter (D50) of about 6.6 $\mu$m, a thickness of about 2 $\mu$m, and an Ig-loss of 0.28 % by weight at about 538°C
- Conductive filler #2: Flake-type silver powder having a tap density of about 4.9 g/$cm^3$, a specific surface area of about 0.40 $m^2$/g, an average particle diameter (D50) of about 6.5 $\mu$m, a thickness of about 2 $\mu$m, and an Ig-loss of 0.27 % by weight at about 538°C and surface-treated with fatty acids
- Conductive filler #3: Flake-type silver powder having a tap density of about 5.3 g/$cm^3$, a specific surface area of about 0.79 $m^2$/g, an average particle diameter (D50) of about 2.7 $\mu$m, a thickness of about 6 $\mu$m, and an Ig-loss of 0.43 % by weight at about 538°C
- Tackifier: 3-glycididoxy propyltrimethoxy silane
- Curing catalyst: Platinum-divinyltetramethyldisiloxane complex
- Reaction inhibitor: 1-ethynyl-1-cyclohexanol

**Examples 1 to 6 and Comparative Examples 1 and 2**

A silicone-based resin composition was prepared by adding each composition shown in Table 1 below to a planetary mixer and uniformly mixing at room temperature at a speed of about 40 rpm for 1 hour.

[Table 1]

| Classification | Organic polysiloxane #1 | Organic polysiloxane #2 | Organic polysiloxane #3 | Conductive filler #1 | Conductive filler #2 | Conductive filler #3 | Tackifier | Curing catalyst | Reaction inhibitor |
|---|---|---|---|---|---|---|---|---|---|
| Unit | % by weight | | | | | | | | |
| Example 1 | 7.5 | 1.3 | 0.5 | 90 | Not contained | Not contained | 0.5 | 0.1 | 0.1 |
| Example 2 | 7.5 | 1.3 | 0.5 | Not contained | 90 | Not contained | 0.5 | 0.1 | 0.1 |
| Example 3 | 7.5 | 1.3 | 0.5 | 88 | 2 | Not contained | 0.5 | 0.1 | 0.1 |
| Example 4 | 7.5 | 1.3 | 0.5 | 2 | 88 | Not contained | 0.5 | 0.1 | 0.1 |
| Example 5 | 9.5 | 1.3 | 0.5 | 88 | Not contained | Not contained | 0.5 | 0.1 | 0.1 |
| Example 6 | 9.5 | 1.3 | 0.5 | Not contained | 88 | Not contained | 0.5 | 0.1 | 0.1 |
| Comparative Example 1 | 7.5 | 1.3 | 0.5 | Not contained | Not contained | 90 | 0.5 | 0.1 | 0.1 |
| Comparative Example 2 | 2.5 | 1.3 | 0.5 | Not contained | Not contained | 95 | 0.5 | 0.1 | 0.1 |

## Experimental Example

<Manufacture of sheet >

The silicone-based resin composition of each of Examples 1 to 6 and Comparative Examples 1 and 2 was molded by hot press under conditions of 165°C and a pressure of 26 kgf/cm$^2$ for 15 minutes to manufacture a sheet.

### Experimental Example 1 - Measurement of hardness and thermal conductivity of first cured product

Each of the manufactured sheets was cured at 150°C for 5 minutes to manufacture a first cured product. Next, the first cured product was subjected to measurement of a Shore A hardness according to ASTM D-2240 and the unit was expressed as the Shore A scale. In addition, the thermal conductivity of the first cured product was measured at 25°C using a thermal conductivity analyzer (model name: TPS-2500S, manufacturer: Hot Disk AB) according to the ISO 22007-2 method. Results are shown in Table 2 below.

### Experimental Example 2 - Measurement of hardness and thermal conductivity of second cured product

The first cured product was cured at 150°C for 120 minutes to manufacture a second cured product. Next, the hardness and thermal conductivity of the second cured product were measured in the same manner as in Experimental Example 1. Results are shown in Table 2 below.

### Experimental Example 3 - Adhesion evaluation

The lap shear strength of each of the second cured products of Examples 1 to 6 and Comparative Examples 1 and 2 was measured using a tensile strength analyzer (manufacturer: ZwickRoell Gmbh) according to DIN EN 1465. Results are shown in Table 2 below.

### Experimental Example 4 - Moldability evaluation

In the process of preparing the silicone-based resin compositions of Examples 1 to 6 and Comparative Examples 1 to 2 in sheet form, the case where the operation of pouring into a mold can be easily completed was classified as "0" and the case where handling is difficult due to excessively high viscosity and it is difficult to pour into a mold was classified as "X." Results are shown in Table 2 below.

[Table 2]

| Classification | First cured product | | Second cured product | | H2-H1 5 | $\|TC_{H2}$ $TC_{H1}\|$ 6) | $[(\|TC_{H2}-TC_{H1}\|)/(H2-H1)] \times 100$ 7) | $(\|TC_{H2}-TC_{H1}\|/TC_{H2}) \times 100$ 8) | Lap shear strength | Moldability evaluation |
|---|---|---|---|---|---|---|---|---|---|---|
| | H1 1) | $TC_{H1}$ 2) | H2 3) | $TC_{H2}$ 4) | | | | | | |
| Unit | - | W/nK | - | W/nK | - | W/mK | % | % | N/mm$^2$ | - |
| Example 1 | 3 | 6.6 | 15 | 6.7 | 12 | 0.1 | 0.83 | 1.49 | 3.0 | O |
| Example 2 | 3 | 6.7 | 15 | 6.8 | 12 | 0.1 | 0.83 | 1.47 | 3.3 | O |
| Example 3 | 4 | 6.9 | 15 | 7.0 | 11 | 0.1 | 0.91 | 1.43 | 3.0 | O |
| Example 4 | 3 | 6.9 | 15 | 7.0 | 12 | 0.1 | 0.83 | 1.43 | 3.2 | O |
| Example 5 | 2 | 6.5 | 15 | 9.1 | 13 | 2.6 | 20.00 | 28.57 | 4.0 | O |
| Example 6 | 2 | 6.2 | 14 | 8.8 | 12 | 2.6 | 21.67 | 29.55 | 4.0 | O |
| Comparative Example 1 | 67 | 5.1 | 73 | 10.4 | 6 | 5.3 | 88.33 | 50.96 | 1.0 | O |
| Comparative Example 2 | 71 | 6.6 | 81 | 11.0 | 10 | 4.4 | 44.00 | 40.00 | 0.1 | X |

(continued)

| Classification | First cured product | | Second cured product | | H2-H1 5 | \| $TC_{H2}$ $TC_{H1}$ \| 6) | [( \| $TC_{H2}$ - $TC_{H1}$ \| ) / (H2-H1)] × 100 7) | ( \| $TC_{H2}$ - $TC_{H1}$ \| / $TC_{H2}$) × 100 8) | Lap shear strength | Moldability evaluation |
|---|---|---|---|---|---|---|---|---|---|---|
| | H1 1) | $TC_{H1}$ 2) | H2 3) | $TC_{H2}$ 4) | | | | | | |
| Unit | - | W/nK | - | W/nK | - | W/mK | % | % | N/mm² | - |

1) H1: Shore A hardness of first cured product
2) $TC_{H1}$: Thermal conductivity of first cured product
3) H2: Shore A hardness of second cured product
4) $TC_{H2}$: Thermal conductivity of second cured product
5) H2-H1: Change in Shore A hardness of first cured product and second cured product
6) | $TC_{H2}$ - $TC_{H1}$ | : Change in thermal conductivity of first cured product and second cured product
7) [( | $TC_{H2}$ - $TC_{H1}$ | ) / (H2-H1)] × 100: Relative ratio of change in thermal conductivity to change in Shore A hardness of first cured product and second cured product
8) ( | $TC_{H2}$ - $TC_{H1}$ | / $TC_{H2}$) × 100: Thermal conductivity change rate of first cured product and second cured product

Referring to Tables 1 and 2, it was confirmed that, in Examples 1 to 6, the amount of change in thermal conductivity, the amount of change in thermal conductivity to the amount of change in hardness, and the thermal conductivity change rate were significantly decreased, compared to Comparative Examples 1 and 2. Accordingly, Examples 1 to 6 exhibit a small variation in the thermal conductivity of the products even if the products exhibit different hardness due to the difference in the process, so that the reliability of the heat dissipation performance may be improved.

In the case of Comparative Examples 1 and 2, a relative ratio of the change the thermal conductivity to the change in the hardness exceeded 40%, so that a change in the thermal conductivity relatively greatly increased even if the same silicone-based resin composition is used, thereby causing a significant deviation in the heat dissipation performance of the product. In addition, in the case of Comparative Example 2, it was confirmed that the adhesion reliability was lowered even if the content of the conductive filler was increased to improve the thermal conductivity, and formability was lowered due to the increase in viscosity.

[Description of Symbols]

10: silicone-based resin composition
11: sheet
11-1: first cured product
11-2: second cured product
20: mold
30: dry oven
100: circuit board
200: semiconductor package
300: conductive bump
400: heat dissipation part
500: heat conduction layer

## Claims

**1.** A silicone-based resin composition, comprising:

an organic polysiloxane; and
a conductive filler, and

wherein the conductive filler comprises a conductive powder that comprises flake-type particles having a thickness of 0.01 $\mu$m to 5 $\mu$m,
wherein a relative ratio of a change in thermal conductivity to a change in Shore A hardness, measured by a measurement method below, of the silicone-based resin composition is 40% or less:
[Measurement method]

1) The silicone-based resin composition is molded by hot press under conditions of 165°C and a pressure of 26 kgf/cm$^2$ for 15 minutes to manufacture a sheet.
2) The sheet is cured at 150°C for 5 minutes to manufacture a first cured product. The first cured product is subjected to measurement of a Shore A hardness according to ASTM D-2240 and measurement of a thermal conductivity according to ISO 22007-2 at 25°C.
3) The first cured product is cured at 150°C for 120 minutes to manufacture a second cured product. The second cured product is subjected to measurement of a Shore A hardness according to ASTM D-2240 and measurement of a thermal conductivity according to ISO 22007-2 at 25°C temperature.
4) A relative ratio of a change in thermal conductivity to a change in Shore A hardness is calculated according to Equation 1 below:

[Equation 1]

$$[(\left| TC_{H2} - TC_{H1} \right|) / (H2\text{-}H1)] \times 100$$

(where H1 denotes the Shore A hardness of the first cured product, H2 denotes the Shore A hardness of the second cured product, $TC_{H1}$ denotes a thermal conductivity (W/mK) in H1, and TCH2 denotes a thermal conductivity (W/mK) in H2.).

**2.** The silicone-based resin composition according to claim 1, wherein the silicone-based resin composition has a thermal conductivity change rate of 30% or less calculated according to Equation 2 below:

[Equation 2]

$$(\left| TC_{H2} - TC_{H1} \right| / TC_{H2}) \times 100$$

(where TCH1 and TCH2 are as defined in Equation 1 above.).

**3.** The silicone-based resin composition according to claim 1, wherein a cured product of the silicone-based resin composition has a Shore A hardness of 95 or less according to ASTM D-2240.

**4.** The silicone-based resin composition according to claim 1, wherein the silicone-based resin composition satisfies Equation 3 below:

[Equation 3]

$$Y = 0.0169X + 6.5193$$

(where X denotes a Shore A hardness according to ASTM D-2240 in a cured product of the silicone-based resin composition, Y denotes a thermal conductivity according to ISO 22007-2 at 25°C of a cured product of the silicone-based resin composition, and Y is 6 W/mK to 8 W/mK.).

**5.** The silicone-based resin composition according to claim 4, wherein, when X is in a range of 3 to 57, a coefficient of determination ($R^2$) is 0.95 or more.

**6.** The silicone-based resin composition according to claim 1, wherein the conductive powder has a specific surface area, when measured according to the BET method as defined in the description, of 0.1 m$^2$/g to 1.5 m$^2$/g.

**7.** The silicone-based resin composition according to claim 1, wherein the conductive powder has an average particle

diameter ($D_{50}$), when measured by laser diffraction method, of 1.0 $\mu$m to 20.0 $\mu$m.

8. The silicone-based resin composition according to claim 1, wherein an ignition loss of the conductive powder, when measured at a temperature of 538°C for one hour, is 0.4 % by weight or less.

9. A semiconductor device, comprising:

a semiconductor package;
a heat dissipation part disposed on the semiconductor package; and
a heat conduction layer interposed between the semiconductor package and the heat dissipation part,
wherein the heat conduction layer comprises a silicone-based resin composition,
the silicone-based resin composition comprises organic polysiloxane and a conductive filler according to claim 1, and
a relative ratio of a change in thermal conductivity to a change in Shore A hardness, measured by a measurement method below, of the silicone-based resin composition is 40% or less:

[Measurement method]

1) The silicone-based resin composition is molded by hot press under conditions of 165°C and a pressure of 26 kgf/cm$^2$ for 15 minutes to manufacture a sheet.
2) The sheet is cured at 150°C for 5 minutes to manufacture a first cured product. The first cured product is subjected to measurement of a Shore A hardness according to ASTM D-2240 and measurement of a thermal conductivity according to ISO 22007-2 at 25°C.
3) The first cured product is cured at 150°C for 120 minutes to manufacture a second cured product. The second cured product is subjected to measurement of a Shore A hardness according to ASTM D-2240 and measurement of a thermal conductivity according to ISO 22007-2 at 25°C temperature.
4) A relative ratio of a change in thermal conductivity to a change in Shore A hardness is calculated according to Equation 1 below:

[Equation 1]

$$[(\left| TC_{H2} - TC_{H1} \right|) / (H2\text{-}H1)] \times 100$$

(where H1 denotes the Shore A hardness of the first cured product, H2 denotes the Shore A hardness of the second cured product, $TC_{H1}$ denotes a thermal conductivity (W/mK) in H1, and TCH2 denotes a thermal conductivity (W/mK) in H2.).

**Patentansprüche**

1. Harzzusammensetzung auf Silikonbasis, umfassend:

ein organisches Polysiloxan und
einen leitfähigen Füllstoff,
wobei der leitfähige Füllstoff ein leitfähiges Pulver umfasst, das Partikel vom Flockentyp mit einer Dicke von 0,01 $\mu$m bis 5 $\mu$m umfasst,
wobei das relative Verhältnis einer Änderung der Wärmeleitfähigkeit zu einer Änderung der Shore-A-Härte, gemessen durch das folgende Messverfahren, der Harzzusammensetzung auf Silikonbasis 40 % oder weniger beträgt:
[Messverfahren]

1) Die Harzzusammensetzung auf Silikonbasis wird durch 15-minütiges Heißpressen unter Bedingungen von 165 °C und einem Druck von 26 kgf/cm$^2$ geformt, unter Bildung einer Folie.
2) Die Folie wird 5 Minuten bei 150 °C gehärtet, unter Bildung eines ersten gehärteten Produkts. Das erste gehärtete Produkt wird einer Messung der Shore-A-Härte gemäß ASTM D-2240 und einer Messung der Wärmeleitfähigkeit gemäß ISO 22007-2 bei 25 °C unterzogen
3) Das erste gehärtete Produkt wird 120 Minuten bei 150 °C gehärtet, unter Bildung eines zweiten gehärteten

Produkts. Das zweite gehärtete Produkt wird einer Messung der Shore-A-Härte gemäß ASTM D-2240 und einer Messung der Wärmeleitfähigkeit gemäß ISO 22007-2 bei einer Temperatur von 25 °C unterzogen 4) Das relative Verhältnis einer Änderung der Wärmeleitfähigkeit zu einer Änderung der Shore-A-Härte wird gemäß folgender Gleichung 1 berechnet:

[Gleichung 1]

$$[(|TC_{H2} - TC_{H1}|)/(H2-H1)] \times 100$$

(wobei H1 die Shore-A-Härte des ersten gehärteten Produkts, H2 die Shore-A-Härte des zweiten gehärteten Produkts, $TC_{H1}$ eine Wärmeleitfähigkeit (W/mK) in H1 und TCH2 eine Wärmeleitfähigkeit (W/mK) in H2 bezeichnet).

**2.** Harzzusammensetzung auf Silikonbasis nach Anspruch 1, wobei die Harzzusammensetzung auf Silikonbasis eine Wärmeleitfähigkeitsänderungsrate von 30 % oder weniger aufweist, berechnet gemäß der folgenden Gleichung 2:

[Gleichung 2]

$$(|TC_{H2} - TC_{H1}|/TC_{H2}) \times 100$$

(wobei TCH1 und TCH2 wie in Gleichung 1 oben definiert sind) .

**3.** Harzzusammensetzung auf Silikonbasis nach Anspruch 1, wobei ein gehärtetes Produkt der Harzzusammensetzung auf Silikonbasis eine Shore-A-Härte von 95 oder weniger gemäß ASTM D-2240 aufweist.

**4.** Harzzusammensetzung auf Silikonbasis nach Anspruch 1, wobei die Harzzusammensetzung auf Silikonbasis die folgende Gleichung 3 erfüllt:

[Gleichung 3]

$$Y = 0{,}0169X + 6{,}5193$$

(wobei X eine Shore-A-Härte gemäß ASTM D-2240 in einem gehärteten Produkt der Harzzusammensetzung auf Silikonbasis bezeichnet, Y eine Wärmeleitfähigkeit gemäß ISO 22007-2 bei 25 °C eines gehärteten Produkts der Harzzusammensetzung auf Silikonbasis bezeichnet und Y 6 W/mK bis 8 W/mK beträgt).

**5.** Harzzusammensetzung auf Silikonbasis nach Anspruch 4, wobei, wenn X in einem Bereich von 3 bis 57 liegt, ein Bestimmungskoeffizient ($R^2$) 0,95 oder mehr beträgt.

**6.** Harzzusammensetzung auf Silikonbasis nach Anspruch 1, wobei das leitfähige Pulver eine spezifische Oberfläche, gemessen gemäß dem in der Beschreibung definierten BET-Verfahren, von 0,1 $m^2/g$ bis 1,5 $m^2/g$ aufweist

**7.** Harzzusammensetzung auf Silikonbasis nach Anspruch 1, wobei das leitfähige Pulver einen durchschnittlichen Teilchendurchmesser ($D_{50}$) , gemessen durch Laserbeugungsverfahren, von 1,0 $\mu$m bis 20,0 $\mu$m aufweist.

**8.** Harzzusammensetzung auf Silikonbasis nach Anspruch 1, wobei ein Glühverlust des leitfähigen Pulvers, gemessen bei einer Temperatur von 538 °C über eine Stunde, 0,4 Gew.-% oder weniger beträgt.

**9.** Halbleitervorrichtung, umfassend:

ein Halbleiterpaket,
einen Wärmeableitungsteil, der auf dem Halbleiterpaket angeordnet ist, und
eine Wärmeleitungsschicht, die zwischen dem Halbleiterpaket und dem Wärmeableitungsteil angeordnet ist, wobei die Wärmeleitungsschicht eine Harzzusammensetzung auf Silikonbasis umfasst,
die Harzzusammensetzung auf Silikonbasis organisches Polysiloxan und einen leitfähigen Füllstoff nach Anspruch 1 umfasst und
das relative Verhältnis einer Änderung der Wärmeleitfähigkeit zu einer Änderung der Shore-A-Härte, gemessen durch das folgende Messverfahren, der Harzzusammensetzung auf Silikonbasis 40 % oder weniger

beträgt:
[Messverfahren]

1) Die Harzzusammensetzung auf Silikonbasis wird durch 15-minütiges Heißpressen unter Bedingungen von 165 °C und einem Druck von 26 kgf/cm$^2$ geformt, unter Bildung einer Folie.
2) Die Folie wird 5 Minuten bei 150 °C gehärtet, unter Bildung eines ersten gehärteten Produkts. Das erste gehärtete Produkt wird einer Messung der Shore-A-Härte gemäß ASTM D-2240 und einer Messung der Wärmeleitfähigkeit gemäß ISO 22007-2 bei 25 °C unterzogen
3) Das erste gehärtete Produkt wird 120 Minuten bei 150 °C gehärtet, unter Bildung eines zweiten gehärteten Produkts. Das zweite gehärtete Produkt wird einer Messung der Shore-A-Härte gemäß ASTM D-2240 und einer Messung der Wärmeleitfähigkeit gemäß ISO 22007-2 bei einer Temperatur von 25 °C unterzogen
4) Das relative Verhältnis einer Änderung der Wärmeleitfähigkeit zu einer Änderung der Shore-A-Härte wird gemäß folgender Gleichung 1 berechnet:

[Gleichung 1]

$$[(|TC_{H2} - TC_{H1}|)/(H2-H1)] \times 100$$

(wobei H1 die Shore-A-Härte des ersten gehärteten Produkts, H2 die Shore-A-Härte des zweiten gehärteten Produkts, $TC_{H1}$ eine Wärmeleitfähigkeit (W/mK) in H1 und TCH2 eine Wärmeleitfähigkeit (W/mK) in H2 bezeichnet).

## Revendications

**1.** Composition de résine à base de silicone, comprenant :

un polysiloxane organique ; et
une charge conductrice et
la charge conductrice comprenant une poudre conductrice qui comprend des particules de type paillette ayant une épaisseur de 0,01 μm à 5 μm,
un rapport relatif d'un changement de conductivité thermique sur un changement de dureté Shore A, mesuré par une méthode de mesure ci-dessous, de la composition de résine à base de silicone étant inférieur ou égal à 40 % :
[Méthode de mesure]

1) la composition de résine à base de silicone est moulée par presse à chaud dans des conditions de 165 °C et de pression de 26 kgf/cm$^2$ pendant 15 minutes pour fabriquer une feuille ;
2) la feuille est durcie à 150 °C pendant 5 minutes pour fabriquer un premier produit durci ; le premier produit durci est soumis à une mesure d'une dureté Shore A selon la norme ASTM D-2240 et à une mesure d'une conductivité thermique selon la norme ISO 22007-2 à 25 °C ;
3) le premier produit durci est durci à 150 °C pendant 120 minutes pour fabriquer un second produit durci ; le second produit durci est soumis à une mesure d'une dureté Shore A selon la norme ASTM D-2240 et à une mesure d'une conductivité thermique selon la norme ISO 22007-2 à une température de 25 °C ;
4) un rapport relatif d'un changement de conductivité thermique sur un changement de dureté Shore A est calculé selon l'équation 1 ci-dessous :

[Équation 1]

$$[(|TC_{H2} - TC_{H1}|)/(H2-H1)] \times 100$$

(où H1 désigne la dureté Shore A du premier produit durci, H2 désigne la dureté Shore A du second produit durci, $TC_{H1}$ désigne une conductivité thermique (W/mK) en H1 et TCH2 désigne une conductivité thermique (W/mK) en H2) .

**2.** Composition de résine à base de silicone selon la revendication 1, la composition de résine à base de silicone ayant un taux de changement de conductivité thermique calculé selon l'équation 2 ci-dessous inférieur ou égal à 30 % :

[Équation 2]

$$(|TC_{H2} - TC_{H1}|/TC_{H2}) \times 100$$

(où TCH1 et TCH2 sont tels que définis dans l'équation 1 ci-dessus).

**3.** Composition de résine à base de silicone selon la revendication 1, un produit durci de la composition de résine à base de silicone ayant une dureté Shore A selon la norme ASTM D-2240 inférieure ou égale à 95.

**4.** Composition de résine à base de silicone selon la revendication 1, la composition de résine à base de silicone satisfaisant à l'équation 3 ci-dessous :

[Équation 3]

$$Y = 0,0169X + 6,5193$$

(où X désigne une dureté Shore A selon la norme ASTM D-2240 dans un produit durci de la composition de résine à base de silicone, Y désigne une conductivité thermique selon la norme ISO 22007-2 à 25 °C d'un produit durci de la composition de résine à base de silicone et Y est de 6 W/mK à 8 W/mK).

**5.** Composition de résine à base de silicone selon la revendication 4, un coefficient de détermination ($R^2$), lorsque X est dans une plage de 3 à 57, étant supérieur ou égal à 0,95.

**6.** Composition de résine à base de silicone selon la revendication 1, la poudre conductrice ayant une surface spécifique, lorsqu'elle est mesurée selon la méthode BET telle que définie dans la description, de 0,1 $m^2/g$ à 1,5 $m^2/g$.

**7.** Composition de résine à base de silicone selon la revendication 1, la poudre conductrice ayant un diamètre moyen des particules ($D_{50}$), lorsqu'il est mesuré par une méthode de diffraction laser, de 1,0 μm à 20,0 μm.

**8.** Composition de résine à base de silicone selon la revendication 1, une perte au feu de la poudre conductrice, lorsqu'elle est mesurée à une température de 538 °C pendant une heure, étant inférieure ou égale à 0,4 % en poids.

**9.** Dispositif à semi-conducteur, comprenant :

un boîtier de semi-conducteur ;
un élément de dissipation de la chaleur disposé sur le boîtier de semi-conducteur ; et
une couche de conduction de la chaleur intercalée entre le boîtier de semi-conducteur et l'élément de dissipation de la chaleur,
la couche de conduction de la chaleur comprenant une composition de résine à base de silicone,
la composition de résine à base de silicone comprenant un polysiloxane organique et une charge conductrice selon la revendication 1 et
un rapport relatif d'un changement de conductivité thermique sur un changement de dureté Shore A, mesuré par une méthode de mesure ci-dessous, de la composition de résine à base de silicone étant inférieur ou égal à 40 % :
[Méthode de mesure]

1) la composition de résine à base de silicone est moulée par presse à chaud dans des conditions de 165 °C et de pression de 26 $kgf/cm^2$ pendant 15 minutes pour fabriquer une feuille ;
2) la feuille est durcie à 150 °C pendant 5 minutes pour fabriquer un premier produit durci ; le premier produit durci est soumis à une mesure d'une dureté Shore A selon la norme ASTM D-2240 et à une mesure d'une conductivité thermique selon la norme ISO 22007-2 à 25 °C ;
3) le premier produit durci est durci à 150 °C pendant 120 minutes pour fabriquer un second produit durci ; le second produit durci est soumis à une mesure d'une dureté Shore A selon la norme ASTM D-2240 et à une mesure d'une conductivité thermique selon la norme ISO 22007-2 à une température de 25 °C ;
4) un rapport relatif d'un changement de conductivité thermique sur un changement de dureté Shore A est calculé selon l'équation 1 ci-dessous :

[Équation 1]

$$[(|TC_{H2} - TC_{H1}|)/(H2-H1)] \times 100$$

(où H1 désigne la dureté Shore A du premier produit durci, H2 désigne la dureté Shore A du second produit durci, $TC_{H1}$ désigne une conductivité thermique (W/mK) en H1 et TCH2 désigne une conductivité thermique (W/mK) en H2) .

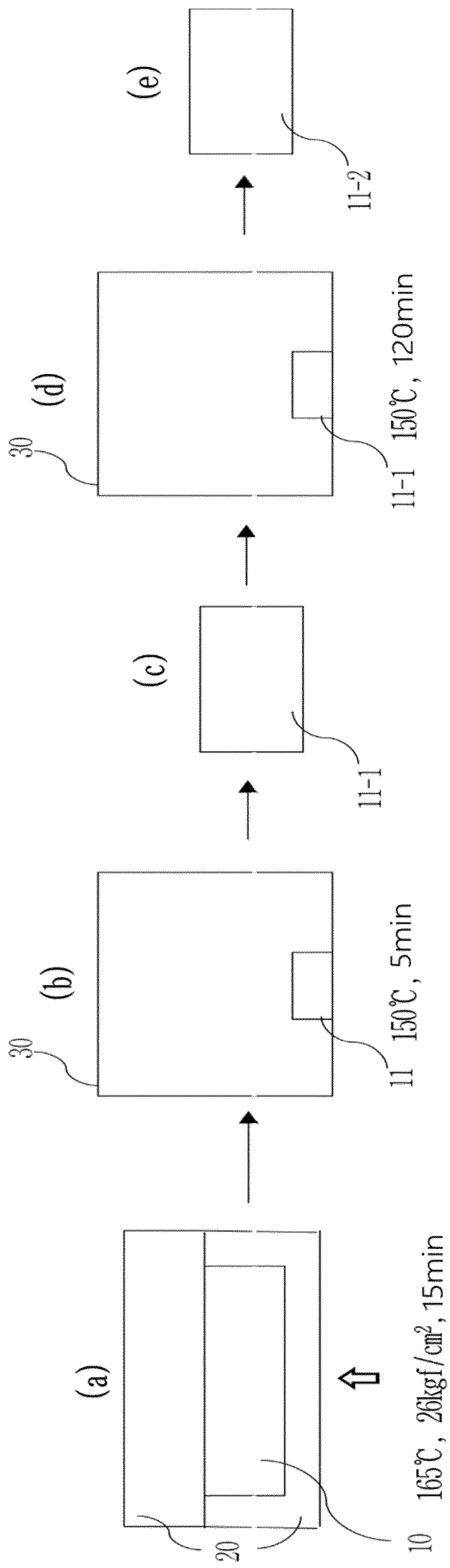
(a)
(b)
(c)
(d)
(e)
10
20
30
11
11-1
11-2
165℃, 26kgf/cm², 15min
150℃, 5min
150℃, 120min

FIG. 1

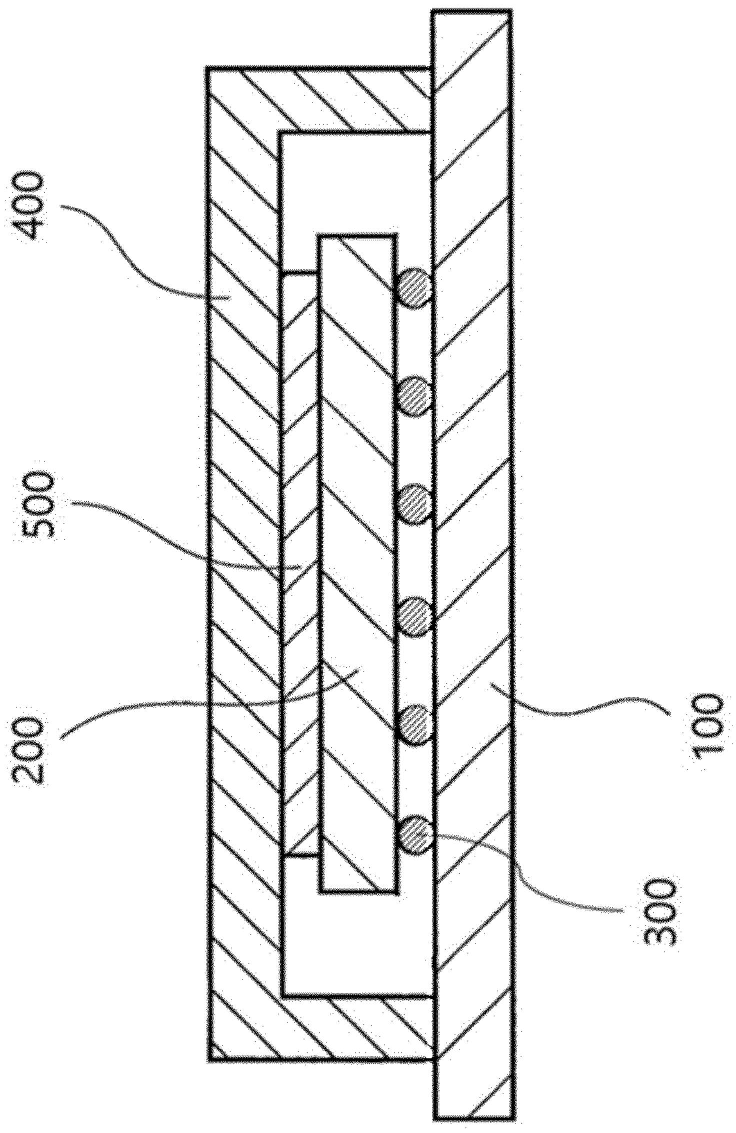


FIG. 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 1020200086307
- EP 3533836 A
- US 2004203268
- CN 109777335
- CN 110079266